Europäisches Patentamt

(19) European Patent Office

Office européen des brevets

(11) Publication number: **0 102 204**
**A1**

(12) # EUROPEAN PATENT APPLICATION

(21) Application number: 83304514.9

(22) Date of filing: 04.08.83

(51) Int. Cl.³: **H 01 L 31/02**
**H 01 L 31/06**

(30) Priority: 04.08.82 US 405072
04.08.82 US 405075

(43) Date of publication of application:
07.03.84 Bulletin 84/10

(84) Designated Contracting States:
BE DE FR GB IT

(71) Applicant: Exxon Research and Engineering Company
P.O.Box 390 180 Park Avenue
Florham Park New Jersey 07932(US)

(72) Inventor: Deckman, Harry William
4 Woods Edge Court
Clinton New Jersey 08809(US)

(72) Inventor: Witzke, Horst
3 Harris Road
Princeton New Jersey 08540(US)

(72) Inventor: Wronski, Christopher Roman
14 Cleveland Lane Road 4
Princeton New Jersey 08540(US)

(72) Inventor: Yablonovitch, Eli
1425 Robin Lane
Scotch Plains New Jersey 07076(US)

(74) Representative: Pitkin, Robert Wilfred et al,
ESSO Engineering (Europe) Ltd. Patents & Licences
Apex Tower High Street
New Malden Surrey KT3 4DJ(GB)

(54) An optically enhanced photovoltaic device.

(57) An optically enhanced thin film photovoltaic device, for example, a solar cell, includes a layer of transparent conductor (2), for example sputter deposited indium-tin-oxide, metallurgically fixed to an active semiconductor layer (6), for example of amorphous silicon. To layer (6) is affixed a layer (8) of reflective material, for example, silver or copper.

The surface of at least one of the layers (2, 6, 8) is textured to include randomly spaced, densely packed microstructures of selected dimensions approximating to the wave-length of visible light in the photovoltaic material. The texturing may suitably be achieved by a lithographic technique.

Preferably a transparent substrate layer (4), suitably of glass or quartz, supports the transparent conductor (2). Preferably, too, the interface surfaces of the substrate (4) and conductor layer (2) are also textured.

FIG. I

The present invention concerns photovoltaic semiconductor devices. In particular, the present invention is a thin film photovoltaic device and a method for making at whose absorption of incident radiation is enhanced. Examples of photovoltaic semiconductor devices include solar cells, and photodiodes. The following discussion will be directed towards a solar cell as a specific example of a photovoltaic device.

Absorption of light in a solar cell is governed by the optical properties of the semiconductor materials used to form the active layers of the cell. Optical absorption in the active layers imposes constraints on the minimum thickness of the semiconductor materials used to form the cell. Such thickness requirements impose severe purity constraints on the semiconductor materials. This follows because the purity of the active material determines the lifetime of the electron hole pair that is generated by the absorbed sunlight. The lifetime determines the average length or collection width over which carriers can be collected in the device. To maximize this requires high purity active material. Therefore, it is desirable to enhance the effective absorption within the active material because (1) the thickness of the active material can be reduced and (2) semiconductor purity requirements can be relaxed.

These considerations are particularly important for amorphous and indirect gap semiconductors. In indirect gap semiconductors, like silicon, the solar radiation is weakly absorbed. For silicon more than 50 microns of material is required to effectively absorb solar radiation. If the optical absorption were enhanced, thinner cell thickness would be required and lower purity material could be used. In amorphous silicon, blue light is absorbed in a thickness of less than $1\mu$ m while near infrared radiation (750-800 nm) requires at least $10\mu$ m for complete absorption. Since the cell must have a minimum thickness to allow for absorption of incident sunlight, the collection width must be of the order of the cell thickness to allow for the generated electron-hole pairs to contribute to the electric current. Since the collection width for amorphous silicon is at best $1.5\mu$ m, optical enhancement could provide a significant improvement in the collection efficiency of near infrared radiation. This in turn should allow the overall cell efficiency to be increased.

In the past decade, there have been a number of suggestions for the use of light trapping by total internal reflection to increase the effective absorption in the indirect gap semiconductor, crystalline silicon. The original suggestions (A. E. St. John U.S. Patent 3,487,223 and O. Krumpholz and S. Moslowski, Z. Angew. Phys. 25, 156 (1968) were motivated by the prospect of increasing the response speed of silicon photodiodes while maintaining high quantum efficiency in the near infrared.

Subsequently, it was suggested (D. Redfield App. Phys. Lett. 25, 647 (1974) and D. Redfield U.S. Patent 3,973,994) that light trapping would have important benefits for solar cells as well. High efficiency could be maintained while reducing the thickness of semi-conductor material required. Additionally, the constraints on the quality of the silicon could be relaxed since the diffusion length of minority carriers could be reduced proportionate to the degree of intensity enhancement. With such important advantages, interest in this approach has continued, but no significant advances in the design of optically enhanced solar cells have been made.

The present invention is an optically enhanced thin film photovoltaic device and a method for making it.

The device includes a transparent conductor metallurgically fixed to the active semiconductor layer which in turn is affixed a layer of reflective material, wherein the surface of at least one of the layers is textured with randomly spaced, densely packed microstructures of predetermined dimensions of the order of the wavelength of visible light in the semiconductor material.

The method includes the steps of producing an active layer of semiconductor material wherein the surface of at least one side of the active layer is textured such that the surface includes randomly spaced, densely packed microstructures of predetermined dimensions of the order of the wavelength of visible light in the semiconductor material and attaching a reflecting surface directly to one side of the semiconductor material and making an ohmic contact to the material.

Light passes into the semiconductor material where photon absorption generates an electron-hole pair within the diffusion length of the junction. However, some of the incident photons pass through the thin-film semiconductor material unabsorbed. By texturing the reflecting surface in the cell, the weakly absorbed photons can be scattered and partially trapped in the semiconductor material increasing the probability of absorption.

In a preferred embodiment the reflector is a tuned reflector comprised of a layer of transparent conductor attached to a metal. The metal is preferably chosen from the group consisting of silver, copper or gold.

In the preferred method for making the cell, the textured surface is produced by lithographic techniques. The active solar cell is amorphous silicon, which is deposited on the textured surface by glow discharge deposition or sputtering.

Brief Description of the Drawings

Figure 1 shows a schematic diagram of the steps of the method for producing an enhanced thin film solar cell according to the present invention.

Figure 2 shows a schematic diagram of an alternative embodiment of the steps of the method for producing an enhanced thin film solar cell according to the present invention.

Figure 3 shows a schematic diagram of another alternative embodiment of the steps of the method for producing an enhanced thin film solar cell according to the present invention.

Figure 4 shows a graph comparing the collection efficiency as a function of wavelength for enhanced and enhanced solar cells constructed using the embodiment shown in Figure 1. Improvements in collection efficiency above the dashed line are due to optical enhancement.

Figure 5 shows a schematic diagram of a lithographic mask formed according to the method of the present invention.

Figure 6 shows a schematic diagram of an etched surface prepared according to the present invention.

Figure 7 shows the improvement of collection efficiency for a textured cell compared to a flat cell constructed according to the embodiment shown in Figure 1. Both cells were constructed with silver reflectors. Increases significantly above 0% are directly attributable to optical enhancement effects.

Figure 8 shows a graph of the enhancement as a function of wavelength for a solar cell constructed according to the embodiment shown in Figure 2. Increases above the dashed line shown in the figure are due to optical enhancement effects.

Figure 9 shows a graph of the enhancement as a function of wavelength for a solar cell constructed according to the embodiment shown in Figure 3. Increase in the percentage difference in collection efficiency significantly above 0% is due to optical enhancement.

For purposes of description, the present invention shall be described and illustrated by solar cells. It is well known that a solar cell contains a semiconductor layer (or layers) which absorbs light producing electronhole pairs, as well as a junction which separates the electron-hole pairs producing useful electrical energy. The semiconductor layers (or layer) which absorb light will be referred to as the active layers or semiconductor material. The semiconductor material and the layers which provide electrical contacts will be referred to as the solar cell material. A thin film solar cell will be considered to be any cell built up from a substrate which is not part of the solar cell material. A thick film solar cell will be considered to be any cell that can be conveniently fabricated starting with an active layer.

The present invention is an optically enhanced solar cell. The cell includes a transparent conductor, semiconductor material, and a reflecting surface. The semiconductor material is sandwiched between the transparent conductor and the reflecting surface. The reflecting surface may be either simply a metal or a tuned reflector composed of a layer of transparent conductor fixed to the metal. The specific embodiments of the invention are described below.

The present invention also includes a method for making an optically enhanced thin film solar cell. The cell includes a transparent conductor, semiconductor material, and a reflecting surface. The semiconductor material is sandwiched between the transparent conductor and the reflecting surface. The reflecting surface may be either simply a metal or a tuned reflector composed of a layer of transparent conductor fixed to a metal. The specific embodiments of the invention are described below.

For purposes of description, the present invention shall be described and illustrated with a thin film solar cell.

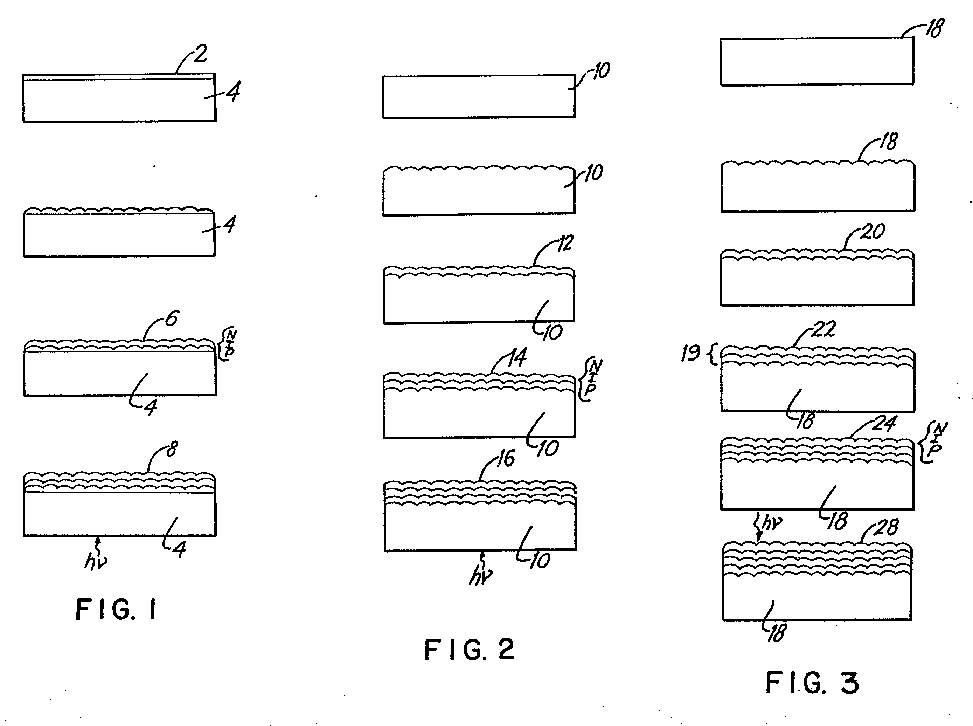

Figure 1 shows a schematic diagram of one of the embodiments of the optically enhanced thin film solar cell. The cell shall be described by the process for producing the thin film solar cell. The first step produces a textured transparent conductor. This is achieved by depositing a transparent conductor 2 onto a transparent substrate 4. The transparent conductor 2 is then textured by lithographic techniques. These techniques produce a surface of microstructures of predetermined dimensions of the order of the wavelength of visible light in the semiconductor material.

After the transparent conductor 2 is textured, semiconductor material 6 is deposited on the textured conductor. The material may be deposited by chemical vapor deposition, physical vapor deposition, sputtering or glow discharge. The solar cell material is deposited so that it conforms to the shape of the textured conductor. In this particular embodiment, the active material is amorphous silicon 6 which is comprised of three distinct layers. A layer P of doped a-SiH$_x$ of p-type is deposited on the transparent conductor 2 and a layer I of intrinsic a-SiH$_x$ is deposited on top of the p-layer with a junction being formed between the P and I layers. A layer N of doped a-SiH$_x$ of n-type is deposited on top of the intrinsic layer I to form an ohmic contact. This particular arrangement of semiconductor material 6 is referred to as a PIN solar cell configuration.

A reflecting surface 8 is then attached to the semiconductor material 6 such that it conforms to the shape of the semiconductor material 6 and makes an ohmic contact with the semiconductor material 6. The reflecting surface 8 may be a simple metal (Ag, Cu, Au) or a tuned reflector comprised of a thin transparent conductor overcoated with a metal.

Figure 2 shows an alternative embodiment of the present invention. In this case, the transparent substrate 10 is textured and a transparent conductor 12 is deposited on the substrate 10 such that the conductor 12 conforms to the shape of the textured substrate 10. The remaining steps are the same as for the embodiment disclosed in Figure 1. That is, the active material 14 is deposited onto the transparent conductor 12 followed by a reflecting surface 16 making an ohmic contact with the semiconductor material 14. The active material 14 in this example is comprised of three distinct layers, namely p-type P, intrinsic I, and n-type N. The reflecting surface 16 may be a simple metal (Ag, Cu, Au) or a tuned reflector comprised of a thin transparent conductor overcoated with a metal. Both the semiconductor material 14 and the reflecting surface 16 conform to the shape of the transparent conductor 12.

Referring to Figure 3, another embodiment of the present invention is shown. In this case the substrate 18 is textured. A reflecting surface 20 is attached to the substrate 18 so as to conform to the shape of the textured surface. A diffusion barrier 22, followed by a layer of semiconductor material 24 and a transparent conductor 26 are added in sequence. As before, the semiconductor material in this example is comprised of three distinct layers namely, p-type P, intrinsic I, and n-type N. The diffusion barrier 22 is a transparent conducting material. The combination of layers 20 and 22 is referred to as a tuned reflector 19. The thickness of the diffusion barrier 22 can be adjusted to minimize the optical absorption in the reflecting surface 20. Each layer conforms to the shape of the preceeding layer. The last layer, the transparent conductor 26, forms an ohmic contact with the semiconductor material 24. A more detailed discussion of the embodiments of the present invention follows below.

The substrate 4, 10, and 18 may be any material suitable for supporting the textured solar cell. It should be noted that the substrate serves only as a support in the embodiment shown in Figure 1. However, the substrate 10 and 18 are themselves textured in the embodiments shown in Figures 2 and 3. It should be noted that in embodiments shown in Figures 1 and 2 the substrates 4 and 10 should be optically transparent. Particularly useful substrates include glass, quartz, fused silica, and sapphire ($Al_2O_3$). In some applications it may be desirable to use a plastic. In the embodiment shown in Figure 3, the substrate 18 need not be transparent. Suitable substrates for the embodiment shown in Figure 3 include steel, aluminum, glass, and quartz.

All of the transparent conductors 2, 12, and 22 should have several properties including, obviously, optical transparency. Any transparent conductors used in combination with the reflectors 8, 12 and 19 to produce tuned reflectors as described above also share the properties of the transparent conductors described in this paragraph. To significantly enhance the efficiency of a solar cell, the transparent conductor should absorb no more than 3% of light in the spectral region of interest. For instance, if an optically enhanced amorphous silicon solar cell is being fabricated, the single pass optical absorption for the transparent conductor should be no more than 3% in the spectral region from 650-800nm. The conductor should also have conductivity $<250 \, \Omega / \square$ . It should not diffuse into the photovoltaic material 6,14 and 24 when that material is deposited. The conductor should be thick enough to texture for those embodiments where the conductor is textured.

In the embodiments shown in Figures 1 to 2, the transparent conductor 2, 12 and 28 should act as an anti-reflection layer. For the transparent conductor to serve as an anti-reflection layer, its optical thickness after texturing should be approximately 1/4 or 3/4 $\lambda$ where $\lambda$ is the wavelength of light in the active layers of the cell. If the active material 6 and 14 in the cell is amorphous silicon, then the average thickness of the transparent conductor should be either 500A or 1,500 A to provide an anti-reflection layer. In the embodiment shown in Figure 3, the thickness of the optically transparent diffusion barrier 22 should be tuned so as to minimize the absorption in the metallic reflector. The optimal thickness of this layer depends on the optical properties of the metallic reflector 20; however, for many applications the optical thickness of the diffusion barrier 22 should be 1/2 $\lambda$. If the active material is a 0.75 $\mu$ m thick layer of amorphous silicon, then the thickness of diffusion barrier 22 should be a 1000 A thick layer to minimize absorption in the metallic reflector. Materials that are suitable as transparent conductors include reactively sputtered indium-tin-oxide (ITO), ITO prepared by chemical vapor deposition, $SnO_2$, $In_2O_3$ and $CdSnO_4$. The preferred material is sputter deposited indium-tin-oxide.

The reflecting surface 8, 16 and 20 may be any material (metal) having low optical absorption and which may be deposited on the cell so as to conform to the textured surface on which it is deposited. It is preferred that the single pass optical absorption in the metal be less than $1/n^2$ of the photons incident where n is the index of refraction for the semiconductor.

If the single pass optical absorption in the metallic reflector is greater than $1/n^2$, then optical enhancement will be greatly diminished. Optical absorption can be minimized by either using a metal which is a good reflector, or by building a tuned reflector. Absorption in the reflector 20 can be minimized by incorporating a thin film of transparent conductor 22 between the active material 24 and metal so as to tune the entire reflector 19. A tuned reflector 19 is shown only in the embodiment of Figure 3. However, a tuned reflector may be included in the embodiments of Figures 1 and 2 as described herein. The reflectivity of the composite tuned reflector 19 depends upon the thickness of the transparent conductor 22 as well as the optical properties of the metal 20. Minimizing optical absorption in the reflector maximizes the enhancement of optical absorption in the active layers of the device.

The reflectivity of a metal in direct contact with a semiconductor having a high index of refraction is significantly less than if it were in contact with air. Thus, many metals which are normally considered to be good reflectors in air, will not produce a large optical enhancement. Table I lists the optical absorption of normally incident light by a flat metal film deposited on a thick layer of $a\text{-}SiH_x$.

Table I

OPTICAL ABSORPTION IN METALS
DEPOSITED ON THICK FILMS OF a-SiH$_x$

| Metal | % Optical Absorption of Metal Deposited on a-SiH$_x$ |
|---|---|
| Ag | $8 \pm 2$ |
| Au | $8 \pm 2$ |
| Cu | $8 \pm 2$ |
| Al | $33 \pm 3$ |
| Mg | $80 \pm 4$ |
| Ni | $61 \pm 3$ |
| Cr | $66 \pm 4$ |
| Pt | $76 \pm 7$ |

In Table I, optical absorption is computed from the optical constants of metals. The refractive index of amorphous silicon is taken to be 4. Light is assumed to be normally incident and wavelength is taken to be 7,500 A.

Inspection of Table I reveals that the preferred reflectors for embodiments shown in Figures 1 and 2 are Cu, Ag and Au. Materials like Al, Ni, Cr and Pt have too much absorption to produce a significant optical enhancement. It should be noted that the optical properties of Cu, Ag and Au are such that solid state plasma oscillations may be strongly excited. Moreover, it has been previously shown [See S. Garoff, D. A. Weitz, T. J. Gramila, and C. D. Hanson, Optics Letters 6, 245 (1981)] that plasmons can produce an increase of optical absorption on roughened surfaces. As such the rough metal surfaces 8, 16 and 20 shown in Figures 1, 2 and 3, respectively, can have optical absorptions significantly greater than that indicated in Table I. Increases in optical absorption by plasmons in the metal will reduce the amount of enhancement obtained. It is thus preferable to minimize the increase of optical absorption due to texturing in Ag, Cu, and Au reflectors. This effect can be minimized by creating surfaces which are rough on scale lengths longer than about 500 A and are smooth at scale lenghts shorter than about 500 A. An example of such a surface is a sinusoidal modulation with a periodicity of 6,000 A. Such surfaces are preferred because roughness on scale lengths less than about 5000 A tends to produce the largest increases in optical absorption. These considerations are most important for metals like Cu, Ag or Au and less important for metals like Al and Ni.

It should be noted that the metallic reflectors must be deposited on the active layer in a manner such that the metal does not diffuse into the semiconductor. Metallic impurities in the semiconductor will decrease the electron hole lifetimes, leading to a degradation in performance of the device. Metals like Cu, Ag, Au, and Al can be deposited by thermal evaporation onto a-SiH$_x$ without any significant diffusion problems.

Rather than use a simple metal as a reflector, it is possible to use a tunable reflector comprised of a metal with a layer of transparent conductor separating it from the active layers. Optical absorption in tunable reflectors should be significantly less than that of a corresponding metallic reflector. Optical absorption in tunable reflectors is minimized thus maximizing optical enhancement. Optical absorption of a metal in contact with a transparent conductor will be significantly less than if it were in contact with a semiconductor. This occurs because the index of refraction (typically about 3) of a semiconductor is much greater than that of a transparent conductor (typically about 2) and the index of refraction determines optical absorption for a metal contacting the aforementioned materials. This can be analytically demonstrated for light normally incident on the interface between the metal and a dielectric medium. For normally incident light the optical absorption in the metal is

$$\text{Fractional Absorption} = 1 - \frac{(n_{metal} - n_{dielectric})^2 + k^2_{metal}}{(n_{metal} + n_{dielectric})^2 + k^2_{metal}}$$

where $n_{metal}$, is the refractive index of the metal, $n_{dielectric}$ is the refractive index of the dielectric and k is the absorption index of the metal. For fixed values of $n_{metal}$ and $k_{metal}$, the fractional absorption monotonically increases with the refractive index of the dielectric.

Thus, a tuned reflector 19 should be superior to a metallic reflector in direct contact with the semiconductor. The performance of a tuned reflector may be optimized by utilizing optical properties of transparent films to further minimize absorption in the metal. For light of a particular wavelength, the transparent conductor thickness can be adjusted to minimize the electric field produced by the light at the metal surface. An exact computation of the optimal transparent conductor thickness requires knowledge of the optical properties of the metallic reflector. For good reflectors the thickness of the transparent conductor should be 1/2 $\lambda$ where $\lambda$ is the wavelength of light at which the photovoltaic device operation is being enhanced. If the tuned reflector is deposited prior to depositing the active material (Figure 3), the transparent conductor must act as a diffusion barrier. If the tuned reflector is deposited after the active layers have been formed, the barrier properties of the transparent conductor are not as important.

The semiconductor material 6, 4, 24 can be any material that can be deposited so as to conform to the textured surface on which it is deposited. Hydrogenated amorphous silicon is particularly useful in that it may be deposited by sputtering or glow discharge. Details of methods for preparing $a\text{-SiH}_x$ by glow discharge techniques have been disclosed in the art. Details of methods for preparing $a\text{-SiH}_x$ with sputtering techniques are also known in the art, see e.g., Sputtered Hydrogenated Amorphous Silicon, T. D. Moustakas, Journal of Electronic Materials, Vol. 8, No. 3, (1979).

To prepare optically enhanced $a\text{-SiH}_x$ solar cells, the deposition methods described below were utilized.

For glow discharge deposition of $a\text{-SiH}_x$, it is preferable to heat the substrate in vacuum to 170-300°C. An optimal substrate temperature is about 215°C. The silane gas should be flowed through the reactor at 30-100 sccm and the pressure in the reactor chamber should be 75-200 mTorr. A glow discharge is initiated in the reactor using at least 7 watts of 13.56 Mhz radio frequency radiation. An optimal radio frequency power is less than 10 watts. The samples are affixed to the electrodes (cathode and anode) and the anode samples are found to be superior to those produced on the cathode. Electrodes are typically about 6 in. disks separated by 1.5 in. The cathode acquires a bias of about -25 volts with respect to the grounded anode. Doping of the $a\text{-SiH}_x$ semiconductor can be accomplished by incorporating 0.7% $B_2H_6$ or $PH_3$ into the gas entering the reactor, resulting in p-type or n-type semiconductors, respectively.

Fabrication of the active layers 6, 14 and 24 of a photovoltaic device requires that a junction be formed in the semiconductor material. To produce a PIN a-SiH$_x$ solar cell, a layer of p doped a-SiH$_x$ can be deposited to a thickness of 300-1600 A. Without shutting off the plasma, the dopant is removed from the gas entering the reactor and 4,000-10,000 A of a-SiH$_x$ is deposited. To provide an ohmic contact to the device, a layer of n-doped a-SiH$_x$ is deposited to a thickness greater than 50 A. An optimal thickness of the n layer is 250 A. A PIN solar cell deposited in this manner is approximately conformal with the shape texturing on the substrate.

Optical absorption in the active layers is enhanced by texturing. Light scattered from a randomly textured surface (or surfaces) can be trapped in the active layer of the cell by internal reflection. The amount of light trapped depends upon the details of the texturing. It has been shown (E. Yablonovitch and G. Cody, IEEE Transactions on Electron Devices ED 300, 1982) that the intensity of light trapped in the active layers never exceeds $4n^2$ (n is the refractive index of the active layers) times the intensity of externally incident light. For semiconductor materials like silicon and a-SiH$_x$, the maximum increase in light intensity within the cell is about 40-75. Optical absorption is proportional to light intensity in the cell so the maximum increase of absorption is about 40-75. Such an increase can only be obtained if there is no optical absorption in the reflector, and if the scattering surface produces a randomization in direction of light in the active layer.

To scatter light in the active layer 6, 14 and 24, a textured surface is produced with randomly spaced, densely packed microstructures of predetermined dimensions. Size of the microstructures is typically of the order of the wavelength of light in the photovoltaic material. Figures 1, 2, and 3 show schematically how a textured surface can be incorporated into a thin film solar cell.

The texturing of the substrate or the transparent conductor is done by etching a pattern in the substrate or conductor after producing a lithographic mask on the surface to be etched. The mask is, preferably, formed by coating a substrate with a monolayer of colloidal particles substantially over the entire surface (about 90%) such that the particles are fixed to the substrate.

The technology of coating a substrate with a monolayer thick random array of colloidal particles is well known. Such coating will be called random colloidal coating and methods for producing them are described by Iler in U.S. Patent 3,485,658, as well as in Iler, Journal of Colloid and Interface Science 21, 569-594 (1966); Iler, Journal of the Americal Ceramic Society 47 (4), 194-198 (1964); Marshall and Kitchener, Journal of Colloid and Interface Science 22, 342-351 (1966); and Peiffer and Deckman, U.S. Patent Application S.N. 55,266 (allowed). These coating techniques deposit a random array of col loidal particles on the substrate because the colloidal particles are electrostatically attracted to the substrates and adhere at the point where they strike the surface. Electrostatic attraction occurs because a surface charge opposite to that of the substrate is induced on the colloidal particles.

The aforementioned surface charge is created by the surface chemistry of the colloid and substrate.

For instance colloidal particles suspended in water acquire a surface charge which may be adjusted by altering the pH of the water. In fact, for many colloidal materials, the pH may be adjusted so that the colloid has zero net charge and this condition is referred to as the isoelectric point. Equivalently, the surface chemistry of most substrate materials produces a surface charge which can be altered by controlling the pH of water in which the substrate is immersed. If the charge on the colloid is opposite to that of the substrate, then a monolayer of colloidal particles can be attracted to the substrate. The time required to attract a monolayer of colloidal particles to the substrate depends on the relative charge of the colloid and substrate as well as the concentration of particles in the colloid. Typically, a monolayer adheres within 1-200 sec when the substrate and colloid are oppositely charged. After the monolayer has been adhered the coated substrate is washed to remove any excess coating material and the substrate is blown dry with air or nitrogen to fix the coating onto the substrate.

If the substrate acquires a charge similar to that of the colloid, then one of two techniques can be used to deposit the colloidal particles. Providing the isoelectric points of the colloid and substrate are different, the pH of the colloidal suspension may be adjusted to produce oppositely charged surfaces. Or if it is not desirable to adjust the pH of the colloid, another colloid having a charge opposite to the substrate and the desired colloid may be deposited to change the sign of the surface charge on the substrate. Preferably, the size of colloidal particles used to reverse the surface charge on the substrate should be small in comparison with the desired colloid. Specifically, the colloid used to reverse the surface charge on the substrate should be sufficiently small so as not to interfere with the lithographic properties of the mask.

The composition of the colloidal particles in the coating may be organic or inorganic and be any material which can be rendered into a colloidal state wherein the particles have charged surfaces. In addition, the particles must have a resistance to the etchant or the deposition material so as to yield the desired pattern. This is discussed further below.

For most applications, the most convenient colloidal particles are polymeric spheres, e.g., polystyrene, polydivinyl benzene, and polyvinyl toluene. Such spheres are usually made by either suspension or emulsion polymerization. Such spheres can be conveniently fabricated in sizes ranging from 500 A to 20 microns.

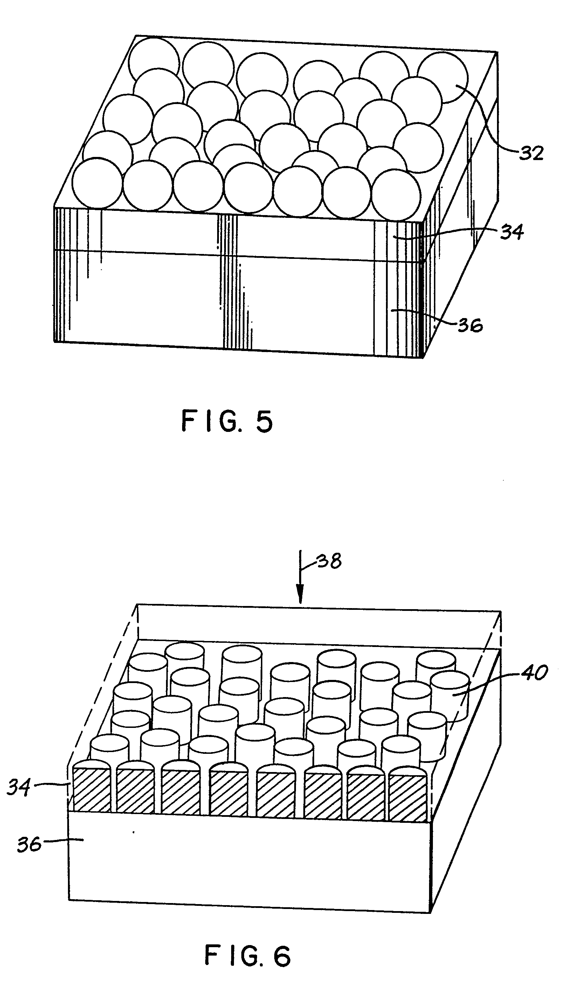

Figure 5 shows a schematic diagram of a lithographic mask produced according to the present invention wherein the colloidal particles are spherical. The mask is an array of colloidal particles 32 adhered to substrate 34. The substrate 34 is the material to be etched and, if necessary, is supported by support 36.

Since the mask 32 is used as an etch mask, a beam of ions 38 is directed at the surface to which are adhered the spheres 32. Figure 6 shows a schematic diagram of microcolumnar posts which have been etched into the surface 34. The incident ion beam etches away the spheres 32 and the surface 34. The relative etching rates of the spheres 32 and surface 34 determine the configuration of the etched surface 34.

The etched pattern is a random array of posts 40. Each post 40 is cylindrical because the directional ion beam etching both the substrate and mask was terminated by the equator of the spherical mask before impinging on the substrate. Continued etching of the mask and substrate such that the diameter of the mask is significantly reduced during the etching process may result in either oblate or prolate spheriod posts depending on the relative etch rates of the mask and substrate.

If the substrate etches faster than the mask then prolate posts will be obtained. A mask which etches faster than the substrate results in oblate posts. Alternatively, a hemispherical morphology could be created by either an isotropic plasma etching process or by causing the polymer to melt during a directional etching process.

An advantage of the present technique for producing lithographic masks is that etched surfaces with random arrays of submicron structures may be rapidly produced over large areas. Characteristic size of the microstructurs can be varied by more than two orders of magnitude because monodisperse spheres are available in sizes ranging from 200 A to 40 $\mu$ m. The mean distance between particles is determined by the technique used to deposit the colloidal particles.

The advantages gained over other lithographic techniques in the case of thin film solar cells are the ability to generate masks for structures of controlled periodicity and aspect ratio on a wide range of materials over large areas in a very short period of time. Masks can be prepared over areas of many square inches in less than one minute. Surfaces made from masks prepared by this technique have allowed significant improvements in the optical absorption properties of thin film solar cells.

To study optical enhancement effects, the quantum efficiency of collection of photogenerated carriers has been measured as a function of wavelength. Techniques for measurement of the collection efficiency of carriers have been discussed by C. R. Wronski and D. E. Carlson, Solid State Comm. $\underline{25}$, 421 (1977), C. R. Wronski, B. Abeles and G. D. Cody, Solar Cells $\underline{2}$, 245 (1980) and C. R. Wronski, B. Abeles, G. Cody and T. Tiedge, Appl. Phys. Lett. $\underline{37}$, 96 (1980).

Optical enhancement techniques improve the collection efficiency of a solar cell in the spectral region where light is weakly absorbed. For a 0.8 $\mu$ m thick a-SiH$_x$ solar cell, improvements in the collection efficiency are expected in the spectral region from 600-800 nm. For a 250 $\mu$ m thick crystalline silicon cell improvement in the collection efficiency should occur in the spectral region from about 1.0 - 1.2 $\mu$ m. Depending upon the spectral region being enhanced, a different microstructure may be used. For a-SiH$_x$ suitable microstructures include 5,000 A diameter posts 1,000-5,000 A high. Another suitable array includes posts with two different diameters of 2,000 and 5,000 A which are etched to a depth of 1,000-4,000 A. It is preferred that the posts be densely packed in a random array. That is, the posts should be as densely packed as possible. If the characteristic lateral dimension of the microstructures is too large, they will not effectively scatter light. For a-SiH$_x$, microstructures larger than 5 $\mu$ m in diameter and less than 0.1 $\mu$ m high are inefficient light scatterers. If the characteristic dimension of the scatterers is significantly less than the wavelength of light in the active layer, light will not be effectively scattered. For a-$SiH_x$, microstructures about 500 A in diameter etched 500 A deep are inefficient light scatters.

For thin film solar cells like a-$SiH_x$, it should be noted that the lithographic texturing does not lead to an increase in the occurrence of shunting. In fact, it is found the lithographically defined texture substantially increases the yield of good cells.

Specifically the short circuit current of an a-$SiH_x$ solar cell has been increased by more than 2mA/cm$^2$. This represents a potential improvement of about 20% in the operating efficiency of an a-$SiH_x$ solar cell.

Utilities of the present invention include enhancement of thick film as well as thin film solar cells. A thick film solar cell will be considered as any cell for which the active layer is not deposited directly on a substrate. To apply the present invention to a thick film solar cell, an array of microstructures can be etched into one side of the active layer. Also, a reflector must be deposited on one side of the active layer and a transparent conductor must be deposited on the opposite side.

EXAMPLE 1

The method shown in Figure 1 was used to prepare optically enhanced a-$SiH_x$ solar cells. A commercially available transparent conductor was textured using the lithographic techniques described below:

a. A 1550 A thick transparent conductor on a piece of EC glass (Corning glass) was half coated with a random array of 5,000 A diameter polymer spheres.

b. A 500ev Ar ion beam was used to etch away 700 $\overset{o}{A}$ of the masked transparent conductor and the polymer spheres were chemically removed.

c. A 8,000 A thick PIN a-SiH$_x$ solar cell was deposited on the textured transparent conductor.

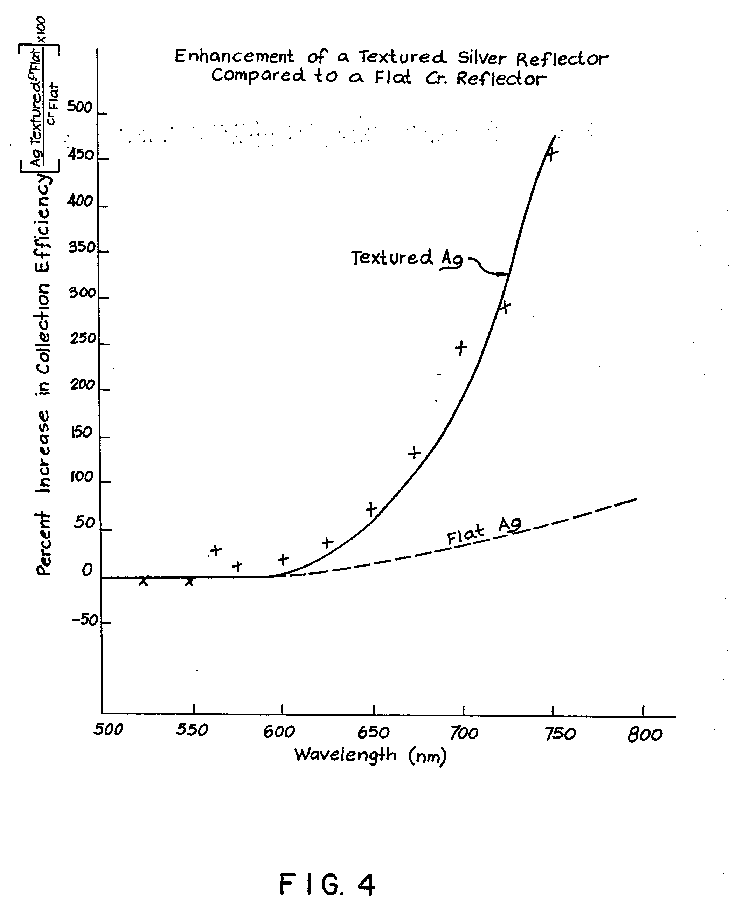

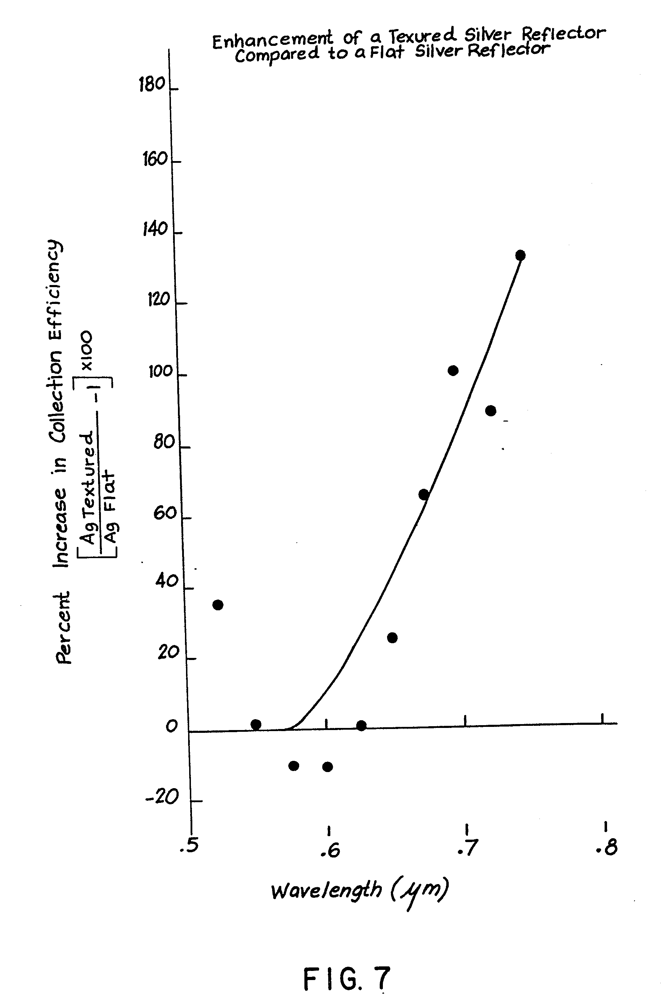

d. Metallic dots of an area about 2mm$^2$ were evaporated through a lithographic mask to form the reflector. The material contained within each dot comprises a complete solar cell. Figure 4 compares the collection efficiency of a textured cell with a silver reflector and a flat cell with a chromium reflector. The dashed line shows the measured behavior if the silver cell were flat. Improvement in the collection efficiency above the dashed line is due to optical enhancement. The improvement in short circuit current due to the textured silver reflector (compared with the flat chromium reflector) is about 2mA/cm$^2$. All measurements of collection efficiency were done with no bias illumination. Figure 7 compares the collection efficiency of flat and textured silver reflectors for a different a-SiH$_x$ deposition. The increase in collection efficiency differences above 0% is directly due to optical enhancement. If the transparent conductor had been thick enough to permit deeper textures, larger effects could have been obtained. Also, improvements can be obtained if the conductor were textured with both 5,000 A and 2,000 A spheres.

EXAMPLE 2

The method shown in Figure 2 was used to prepare optically enhanced a-SiH$_x$ solar cells. Only

half of the substrate was textured so that a side-by-side comparison could be made of flat and textured cells. Details of the method used to prepare the cells are described below:

a. Half of a 1/2 x 1" piece of Corning 7059 glass was coated with an array of 5,000 A spheres.

b. Approximately 5,000 A of glass was removed with a 500ev reactive ion beam produced from a $CF_4$ discharge. The remaining polymer mask was chemically removed.

c. A 500 A layer of indium-tin oxide was sputter deposited on the substrate.

d. Steps 3 and 4 of Example 1 were repeated.

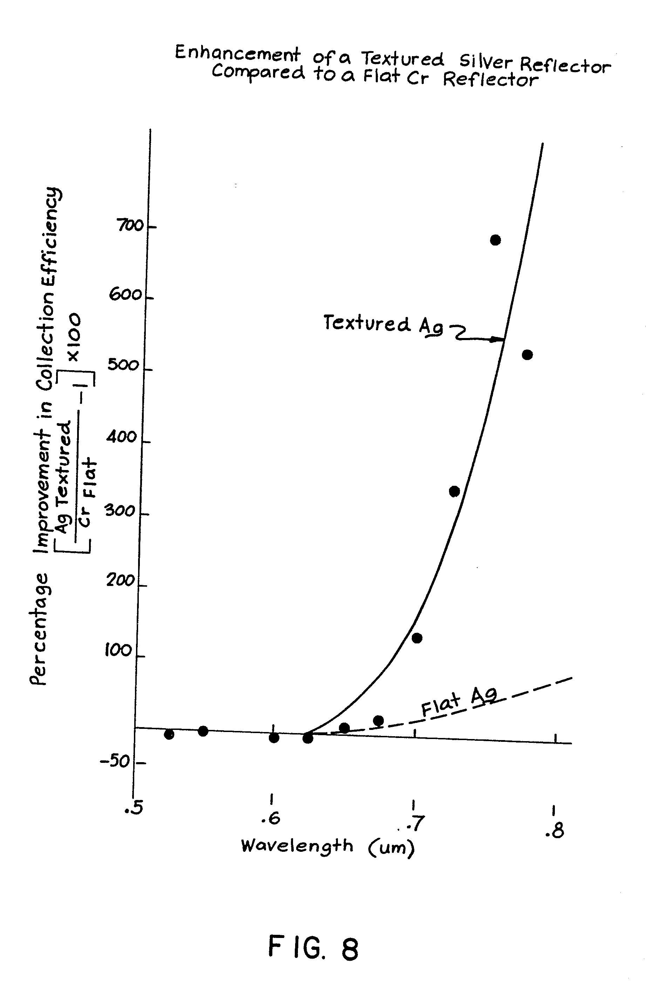

Figure 8 shows the improvement in collection efficiency of a textured silver reflector compared with flat chromium. The dashed line shows the behavior expected if the silver cell were flat. Improvement in the difference of collection efficiencies above the dashed line is due to optical enhancement. The net increase of short circuit current of the textured silver cell over the flat chromium cell is in excess of $2mA/cm^2$ (AM1 conditions).

EXAMPLE 3

The method shown in Figure 3 was used to prepare optically enhanced $a-SiH_x$ solar cells. Only half of the substrate was textured so that a side-by-side comparison could be made of flat and textured cells. Details of the method used to prepare the cells are described below:

a. Half of a 1/2 x 1" piece of Corning 7059 glass was coated with a densely packed random array of 4,000 A polymer spheres.

b. A 500ev reactive ion beam produced from a $CF_4$ gas discharge was used to etch the substrate. Etching of the substrate was terminated after about 5,000 A of glass had been removed. The remaining polymer was chemically removed.

c. A tuned reflector was deposited on the substrate. The metallic layer in the reflector was a 3,500 A thick silver layer evaporated onto the substrate. Absorption in the metallic layer was minimized by sputter coating a about 1,000 A thick indium-tin-oxide film over the silver.

d. The sample was affixed to the cathode of a plasma reactor, and a 10,000 A thick PIN a-SiH$_x$ cell was deposited.

e. To form solar cells 2mm$^2$ dots of indium-tin-oxide were sputter coated on the front surface of the substrate.

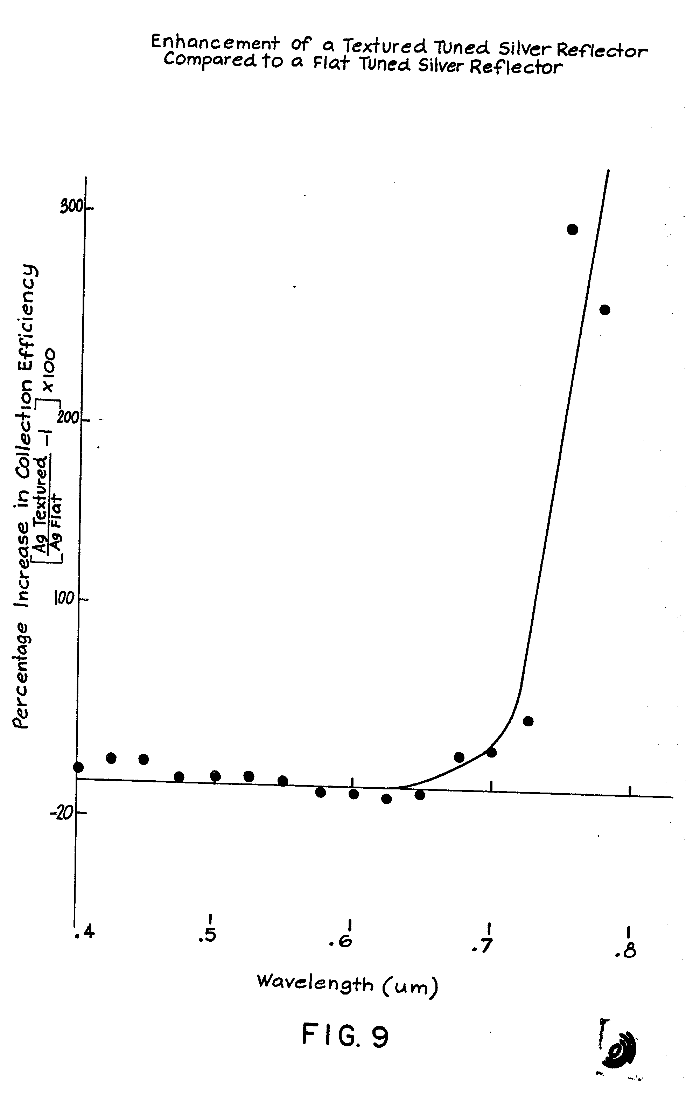

Figure 9 shows the percentage increase in the collection efficiency due to texturing. It should be noted that in this case substantial differences between flat and textured cells only exist for wavelengths longer than 725nm. This is due to the fact that the cell material had a smaller optical bandgap than the material described in Examples 1 and 2. Due to the smaller bandgap, the optical enhancement effects shift to longer wavelength where the light is weakly absorbed.

CLAIMS:

1. An optically enhanced photovoltaic device which is characterised in that it comprises:

(a) a layer of transparent conductor having an upper and lower surface;

(b) a layer of reflecting material having an upper and lower surface;

(c) a layer of active semiconductor material having an upper and lower surface, which active layer is interposed between and metallurgically fixed to or in connection with said layers of transparent conductor and reflecting material; and is further characterised in that at least one of the surfaces is textured such that a said surface includes randomly spaced, densely packed microstructures of predetermined dimensions in the order of the wavelength of visible light in the semiconductor material.

2. A device as claimed in claim 1, further comprising a substrate layer having an upper and lower surface, wherein said upper surface is fixed to said lower surface of said transparent conductor on the side thereof away from said semiconductor layer.

3. A device as claimed in claim 2, wherein the surfaces forming the interface between the substrate and the transparent conductor are substantially flat, and the upper surface of the transparent conductor and the lower surface of said active material are both textured.

4. A device as claimed in claim 2, wherein said upper surface of the substrate is textured and the lower surface of said transparent conductor is conformed thereto.

5.    A device as claimed in claim 3 or claim 4, wherein the surfaces of successive layers of substrate, transparent conductor, semiconductor layer and reflecting material each substantially conform to the shape of the layer to which it is fixed.

6.    A device as claimed in claim 3 or claim 4, wherein the layer of reflecting material is a tuned reflector comprising

(a)    a layer of metal having an upper and lower surface and having low optical absorption; and

(b)    a layer of transparent conductor having an upper and lower surface wherein said lower surface is fixed to the upper surface of the active semiconductor material and said upper surface is  fixed to the lower surface of the metal layer.

7.    A device as claimed in claim 1, further comprising a ubstrate layer having an upper and lower surface wherein the upper surface of the substrate is fixed  to the lower surface of said reflecting material.

8.    A device as claimed in claim 7, wherein the surfaces forming the interface between the substrate and the reflecting material are substantially flat and the upper surface of the reflecting material is textured.

9.    A device as claimed in claim 7, wherein the upper surface of said substrate is textured and all the surfaces of each of the interfaces between all successive layers substantially conform to the shape of the textured surface of the substrate.

10.    A device as claimed in any one of claims 7 to 9, wherein said layer of reflecting material is a tuned reflector comprising

(a)   a layer of metal having an upper and lower surface and having low optical absorption and

(b)   a layer or diffusion barrier of transparent conductor having an upper and lower surface wherein said upper surface is fixed to said lower surface of said active semi- conductor material and said lower surface is fixed to said upper surface of said metal layer.

11.   A method for producing an optically enhanced photovoltaic device characterised by the steps of:

a.   producing an active layer of semiconductor material wherein the surface of at least one side of said active layer is textured such that said surface includes randomly spaced, densely packed microstructures of predetermined dimensions in the order of the wavelength of visible light in said semiconductor material; and

b.   attaching a reflecting surface directly to one side of said semiconductor material and making an ohmic contact to said material.

12.   A method as claimed in claim 11, wherein the step of producing an active layer of semiconductor material comprises:

a.   producing a textured surface transparent conductor, wherein said textured surface includes randomly spaced, densely packed microstructures of predetermined dimensions in the order of the wavelength of visible light in said semiconductor material; and

b.   attaching said active layer of semiconductor material on said transparent conductor forming an ohmic contact, said material conforming to the shape of said textured transparent conductor.

13. A method as claimed in claim 12, wherein said step (a) comprises:

(i) depositing a transparent conductor on a flat light-transparent substrate; and

(ii) texturing said transparent conductor.

14. A method as claimed in claim 11, wherein said step (a) comprises:

(i) texturing one side of a transparent substrate; and

(ii) attaching a transparent conductor on said textured surface of said transparent substrate, said transparent conductor conforming to the shape of said textured surface.

15. A method for producing an optically enhanced photovoltaic device characterised by the stages of:

a. producing a textured surface on a substrate, wherein said textured surface includes randomly spaced, densely packed microstructures of predetermined dimensions in the order of the wavelength of visible light in the semiconductor material of said device;

b. attaching a reflecting surface on said substrate, said reflecting surface conforming to the shape of said textured substrate;

c. attaching a conducting transparent diffusion barrier to said reflecting surface, said diffusion barrier conforming to the shape of said reflecting surface;

d. depositing semiconductor material on said diffusion barrier forming an ohmic contact, said semiconductor material conforming to the shape of said diffusion barrier; and

e. attaching a transparent ohmic contact to said semiconductor material on the side away from said substrate.

16. A method as claimed in claim 11 or claim 15, wherein said texturing step is performed by a lithographic technique, preferably including lithographic mask composed of colloidal particles with sizes ranging from 2,000 A to 10,000 A.

17. A method as claimed in any one of claims 11 to 15, wherein said semiconductor material is amorphous silicon or hydrogenated amorphous silicon or amorphous silicon hydride.

FIG. 1

FIG. 2

FIG. 3

F I G. 4

FIG. 5

FIG. 6

Enhancement of a Textured Silver Reflector
Compared to a Flat Silver Reflector

FIG. 7

Enhancement of a Textured Silver Reflector
Compared to a Flat Cr Reflector

FIG. 8

Enhancement of a Textured Tuned Silver Reflector
Compared to a Flat Tuned Silver Reflector

FIG. 9

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | US-A-4 285 762 (MOUSTAKAS) * Column 4, line 64 - column 5, line 13 * | 1,7 | H 01 L 31/02 H 01 L 31/06 |
| A | | 11,17 | |
| Y | US-A-4 328 390 (MEAKIN et al.) * Column 3, line 58 - column 4, line 14 * | 1,7 | |
| A,D | US-A-3 973 994 (REDFIELD) * Column 2, lines 12-54 * | 1 | |
| A | APPLIED PHYSICS LETTERS, vol. 35, no. 7, 1 October 1979, New York G. CHEEK et al. "Antireflection properties of indium tin oxide (ITO) on silicon for photovoltaic applications", pages 495-497 * Page 495, last paragraph * | 10 | TECHNICAL FIELDS SEARCHED (Int. Cl. 3) H 01 L 31/00 C 23 F 1/02 |
| A,D | US-A-3 485 658 (R.K. ILER) * Claim 1 * | 16 | |

The present search report has been drawn up for all claims

| Place of search BERLIN | Date of completion of the search 11-10-1983 | Examiner GIBBS C.S. |
|---|---|---|

EPO Form 1503. 03.82

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document